# EUROPEAN PATENT APPLICATION

(11) **EP 2 999 007 A1**
(43) Date of publication of application: **23.03.2016**
(21) Application number: 15185636.6
(22) Date of filing: 17.09.2015
(51) Int. Cl.: H01L 31/0224, H01L 31/032, H01L 31/072

(54) **PHOTOELECTRIC CONVERSION DEVICE, AND SOLAR CELL**

(30) Priority: 19.09.2014 JP 2014191890
(71) Applicant: Kabushiki Kaisha Toshiba, Tokyo 105-8001 (JP)
(72) Inventor: Shibasaki, Soichiro, Tokyo, 105-8001 (JP); Yamamoto, Kazushige, Tokyo, 105-8001 (JP); Hiraga, Hiroki, Tokyo, 105-8001 (JP); Nakagawa, Naoyuki, Tokyo, 105-8001 (JP); Yamazaki, Mutsuki, Tokyo, 105-8001 (JP); Saito, Hitomi, Tokyo, 105-8001 (JP); Sakurada, Shinya, Tokyo, 105-8001 (JP); Inaba, Michihiko, Tokyo, 105-8001 (JP)
(74) Representative: Hoffmann Eitle

(57) **Abstract**

A photoelectric conversion device of an embodiment has a bottom electrode, an intermediate layer on the bottom electrode, a p-type light absorbing layer on the intermediate layer, and an n-type layer on the p-type light absorbing layer. The bottom electrode is a first metal film or a semiconductor film. When the bottom electrode is a metal film, the intermediate layer comprises an oxide film or a sulfide film. When the bottom electrode is a semiconductor film, the intermediate layer comprises a second metal film and an oxide film or a sulfide film on the second metal film.

## Description

### CROSS-REFERENCE TO RELATED APPLICATION

This application is based upon and claims the benefit of priority from Japanese Patent Application No. 2014-191890 filed on SEPTEMBER 19, 2014; the entire contents of which are incorporated herein by reference.

### FIELD

Embodiments described herein relate to a photoelectric conversion device and a solar cell.

### BACKGROUND

Compound photoelectric conversion devices having a semiconductor thin film as a light absorbing layer have been developed. In particular, thin-film photoelectric conversion devices having, as a light absorbing layer, a p-type semiconductor layer with a chalcopyrite structure have high conversion efficiency and thus promising applications. Specifically, thin-film photoelectric conversion devices having a light absorbing layer of Cu(In,Ga)Se₂ as a Cu-In-Ga-Se compound, Cu(In,Al)Se₂ as a Cu-In-Al-Se compound, Cu(Al,Ga)Se₂ as a Cu-Al-Ga-Se compound, or CuGaSe₂ as a Cu-Ga-Se compound have relatively high conversion efficiency. A thin-film photoelectric conversion device has a light absorbing layer of a p-type semiconductor layer with a chalcopyrite structure, a kesterite structure, or a stannite structure. Such a thin-film photoelectric conversion device generally has a structure including a soda-lime glass substrate, and a molybdenum bottom electrode, a p-type semiconductor layer, an n-type semiconductor layer, an insulating layer, a transparent electrode, a top electrode, and an antireflective film, which are stacked on the substrate. The conversion efficiency η is expressed by η = Voc·Jsc·FF/P·100, wherein Voc is open-circuit voltage, Jsc is short-circuit current density, FF is power factor, and P is incident power density.

This shows that the conversion efficiency increases as the open-circuit voltage, the short-circuit current, and the power factor increase, respectively. Theoretically, as the band gap between the light absorbing layer and the n-type semiconductor layer increases, the open-circuit voltage increases, whereas the short-circuit current density decreases. When the efficiency change is observed as a function of band gap, a maximum exists at about 1.4 to 1.5 eV. It is known that the band gap of Cu(In,Ga)Se₂ increases with Ga concentration and that a photoelectric conversion device with high conversion efficiency can be obtained when Ga/(In + Ga) is controlled between about 0.4 and about 0.8.

### BRIEF DESCRIPTION OF THE DRAWINGS

FIG. 1 is a schematic cross-sectional view of a thin-film photoelectric conversion device according to an embodiment; and
FIG. 2 is a schematic cross-sectional view of a multi-junction photoelectric conversion device according to an embodiment.

### DETAILED DESCRIPTION

A photoelectric conversion device of an embodiment has a bottom electrode, an intermediate layer on the bottom electrode, a p-type light absorbing layer on the intermediate layer, and an n-type layer on the p-type light absorbing layer. The bottom electrode is a first metal film or a semiconductor film. When the bottom electrode is a metal film, the intermediate layer comprises an oxide film or a sulfide film. When the bottom electrode is a semiconductor film, the intermediate layer comprises a second metal film and an oxide film or a sulfide film on the second metal film.

A solar cell of an embodiment has a photoelectric conversion device. The photoelectric conversion device has a bottom electrode, an intermediate layer on the bottom electrode, a p-type light absorbing layer on the intermediate layer, and an n-type layer on the p-type light absorbing layer. The bottom electrode is a first metal film or a semiconductor film. When the bottom electrode is a metal film, the intermediate layer comprises an oxide film or a sulfide film. When the bottom electrode is a semiconductor film, the intermediate layer comprises a second metal film and an oxide film or a sulfide film on the second metal film.

Hereinafter, embodiments will be described in detail with reference to the drawings.

### (Photoelectric conversion device)

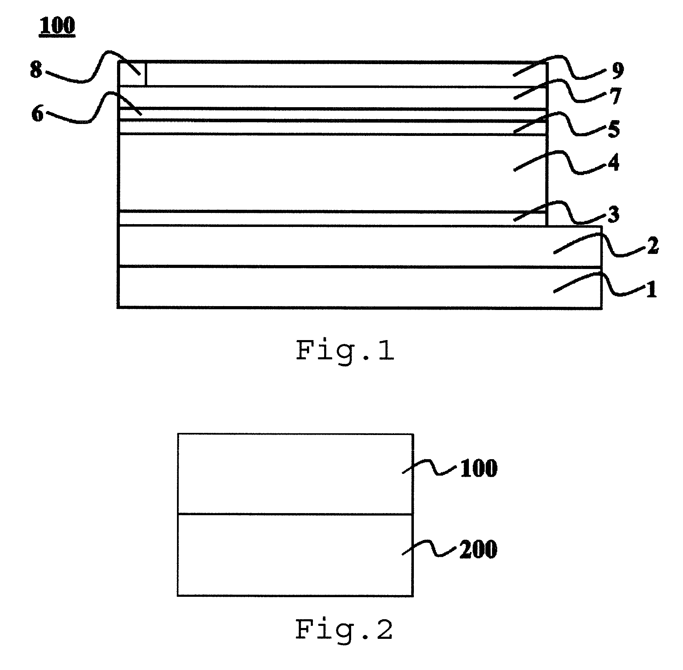

FIG. 1 is a schematic diagram showing a photoelectric conversion device 100 according to an embodiment. The photoelectric conversion device 100 includes a substrate 1, a bottom electrode 2 formed on the substrate 1, an intermediate layer 3 formed on the bottom electrode 2, a p-type light absorbing layer 4 formed on the intermediate layer 3, an n-type layer 5 formed on the p-type light absorbing layer 4, an oxide layer 6 formed on the n-type layer 5, a transparent electrode 7 formed on the oxide layer 6, and a top electrode 8 and an antireflective film 9 each formed on the transparent electrode 7. Specifically, the photoelectric conversion device 100 may be a solar cell. As shown in FIG. 2, the photoelectric conversion device 100 of an embodiment may be joined to another photoelectric conversion device 200 to form a multi-junction device. The light absorbing layer of the photoelectric conversion device 100 preferably has a band gap wider than that of the light absorbing layer of the photoelectric conversion device 200. For example, Si is used to form the light absorbing layer of the photoelectric conversion device 200.

### (Substrate)

In an embodiment, the substrate 1 is preferably made of soda-lime glass, and alternatively, the substrate 1 may be made of quartz, common glass such as white glass, a sheet of a metal such as stainless steel, Ti (titanium), or Cr (chromium), or a resin such as polyimide or acrylic.

### (Bottom electrode)

In an embodiment, the bottom electrode 2 as an electrode of the photoelectric conversion device 100 is a first metal film or a semiconductor film formed on the substrate 1. The bottom electrode 2 may be a conductive metal film (first metal film) including Mo, W, or the like or a semiconductor film including at least indium tin oxide (ITO). The first metal film is preferably a Mo film or a W film. One or more of SnO₂, TiO₂, carrier-doped ZnO:Ga, carrier-doped ZnO:Al, and the like may be deposited on the indium tin oxide. In particular, the bottom electrode 2 may be deposited on the substrate 1 by sputtering or the like. The bottom electrode 2 typically has a thickness of 100 nm to 1,000 nm. When a semiconductor film is used as the bottom electrode 2, ITO and SnO₂ may be stacked from the substrate 1 side to the p-type light absorbing layer 4 side to form the bottom electrode 2, or ITO, SnO₂, and TiO₂ may be stacked from the substrate 1 side to the p-type light absorbing layer 4 side to form the bottom electrode 2. A layer of an oxide such as SiO₂ may be further provided between the substrate 1 and the ITO.

### (Intermediate layer)

In an embodiment, the intermediate layer 3 is formed on the principal surface of the bottom electrode 2 opposite to the substrate 1. To improve the contact between the bottom electrode 2 and the p-type light absorbing layer 4, the intermediate layer 3 is provided between the bottom electrode 2 and the p-type light absorbing layer 4 in the photoelectric conversion device 100 of an embodiment. The improvement of the contact can increase the Voc of the photoelectric conversion device, namely, its voltage, and thus increase its conversion efficiency. The intermediate layer 3 contributes not only to an increase in the conversion efficiency but also to an increase in the peeling resistance of the p-type light absorbing layer 4. When the bottom electrode 2 is the first metal film, the intermediate layer 3 may be a film of an oxide or sulfide containing one or more elements selected from Mg, Ca, Al, Ti, Ta, and Sr. One of the oxide film and the sulfide film may be used alone, or a stack of these films may be used. When the bottom electrode 2 is the first metal film, the intermediate layer 3 is preferably a thin film made of a material used for a tunnel insulating film. Specifically, when the bottom electrode 2 is the first metal film, the intermediate layer 3 may be made of a metal oxide such as MgO, CaO, Al₂O₃, TiO₂, Ta₂O₅, SrTiO₃, MoO₃, or CdO, or a metal sulfide such as ZnS, MgS, CaS, Al₂S₃, TiS₂, Ta₂S₅, SrTiS₃, or CdS. In particular, the intermediate layer 3 is preferably a MgO film. The intermediate layer 3 can be deposited on the bottom electrode 2 by sputtering or the like. When the bottom electrode 2 is the first metal film, the intermediate layer 3 preferably has a thickness of 10 nm or less. When the bottom electrode 2 is the first metal film, the intermediate layer 3 preferably has a thickness of 0.3 nm to 7 nm, more preferably 0.5 nm to 5 nm. If the intermediate layer 3 is too thin, the increase in Voc resulting from the improvement of the contact will be small. If the intermediate layer is too thick, it can have a high resistance to reduce the Jsc. From these points of view, the thickness of the intermediate layer 3 should preferably fall within the above ranges so that the conversion efficiency of the photoelectric conversion device can be improved. If the intermediate layer 3 is too thin, damage-induced mixing can occur during the deposition of it, so that the effects of providing the intermediate layer 3 will be insufficient in some cases. In addition, if too thin, the intermediate layer 3 will be difficult to form uniformly, so that the effects of providing the intermediate layer 3 will be insufficient in some cases. On the other hand, if too thick, the intermediate layer 3 will have too high a series-resistance, which can reduce the Jsc and therefore is not preferred. If the intermediate layer 3 has a high resistance close to that of an insulator and is made too thick, it will have a higher series-resistance, which is more undesirable.

When the bottom electrode 2 is a semiconductor film, the intermediate layer 3 is preferably a second metal film or a stack of a second metal film and an oxide film or a sulfide film provided on the second metal film. In the case of the stack, the second metal film is located on the bottom electrode 2 side, and the oxide or sulfide film on the second metal film is located on the p-type light absorbing layer 4 side. The oxide or sulfide film contains one or more elements selected from Mg, Ca, Al, Ti, Ta, and Sr. One of the oxide film and the sulfide film may be used alone, or a stack of these films may be used. When the bottom electrode 2 is a semiconductor film, the second metal film as the intermediate layer 3 is typically a film including Mo or W, preferably a Mo film or a W film. When the bottom electrode 2 is a semiconductor film, the second metal film preferably has a thickness of 10 nm or less, and the oxide or sulfide film or a stack of these films preferably has a thickness of 10 nm or less. If the metal film is too thick, the photoelectric conversion device of an embodiment provided as a top cell to form a multi-junction photoelectric conversion device (solar cell) can reduce the transmittance of light to the bottom cell side, which is not preferred. When the bottom electrode 2 is a semiconductor film and when the intermediate layer 3 is the second metal film, the metal film preferably has a thickness of 0.3 nm to 7 nm, more preferably 0.5 nm to 5 nm. When the bottom electrode 2 is a semiconductor film and when the intermediate layer 3 is a stack of the second metal film and the oxide or sulfide film provided thereon, the metal film preferably has a thickness of 0.3 nm to 7 nm, more preferably 0.5 nm to 5 nm. If the metal film as the intermediate layer 3 is too thin, the increase in Voc resulting from the improvement of the contact will be small. If the second metal film for the intermediate layer 3 is too thick, the oxide or sulfide film or a stack of these films should preferably has a thickness of 10 nm or less. If the metal film is too thick, the photoelectric conversion device of an embodiment provided as a top cell to form a multi-junction photoelectric conversion device (solar cell) can reduce the transmittance of light to the bottom cell side, which is not preferred. From these points of view, the thickness of the second metal film for the intermediate layer 3 should preferably fall within the above ranges so that the conversion efficiency of the photoelectric conversion device can be increased. When the bottom electrode 2 is a semiconductor film and when the intermediate layer 3 is a stack of the second metal film and the oxide or sulfide film provided thereon, the oxide or sulfide film or a stack of these films preferably has a thickness of 0.3 nm to 5 nm, more preferably 0. 5 nm to 4 nm. If the oxide or sulfide film for the intermediate layer 3 is too thin, the increase in Voc resulting from the improvement of the contact will be small. If the oxide or sulfide film for the intermediate layer 3 is too thick, it can have a high resistance to reduce the Jsc. From these points of view, the thickness of the oxide or sulfide film for the intermediate layer 3 should preferably fall within the above ranges so that the conversion efficiency of the photoelectric conversion device can be increased.

From a 450,000 times magnified image taken with a transmission electron microscope (TEM), the intermediate layer 3 can be identified as a continuous or intermittent film between the bottom electrode 2 and the p-type light absorbing layer 4. The average thickness of the intermediate layer 3 may be defined as the average in a region 1 cm wide from the center of the photoelectric conversion device or may be determined by dividing the photoelectric conversion device into four cross-sections and averaging the values that are each the average in a region 1 cm wide from the center of each cross-section. When the photoelectric conversion device 100 is so small that the 1-cm-wide region cannot be observed, the whole of the intermediate layer 3 should be observed. The composition of the intermediate layer 3 can be identified by energy-dispersive X-ray spectroscopy or secondary ion mass spectrometry.

### (P-type light absorbing layer)

In an embodiment, the p-type light absorbing layer 4 is a p-type compound semiconductor layer. The p-type light absorbing layer 4 is formed on the principal surface of the intermediate layer 3 opposite to the substrate 1. The p-type light absorbing layer 4 may be a layer of a compound semiconductor including a group Ib element or elements, a group IIIb element or elements, and a group VIb element or elements and having a chalcopyrite structure, a stannite structure, or a kesterite structure, such as Cu(In,Ga)Se₂, CuInTe₂, CuGaSe₂, Cu(In,Al)Se₂, Cu(Al,Ga)(S,Se)₂, CuGa(S,Se)₂, or Ag(In,Ga)Se₂. The p-type light absorbing layer 4 typically has a thickness of 800 nm to 3,000 nm. The group Ib element is preferably Cu (copper). The group IIIb element or elements preferably include at least one element selected from the group consisting of Al, In, and Ga, more preferably include at least Ga. The group VIb element or elements preferably include at least one element selected from the group consisting of O, S, Se, and Te, more preferably include at least Se. Among the group IIIb elements, In is more preferred because the band gap can be set to a desired level by using In in combination with Ga. Specifically, the p-type light absorbing layer 4 may include a compound semiconductor such as Cu(In,Ga)(S,Se)₂, Cu(In,Ga) (Se,Te)₂, Cu(In,Ga)₃(Se,Te)₅, Cu(Al,Ga,In)Se₂, Cu(Al,Ga)(S,Se)₂, or Cu₂ZnSnS₄, more specifically, Cu (In, Ga) Se₂, CuInSe₂, CuInTe₂, CuGaSe₂, CuGa(S,Se)₂, CuIn₃Te₅, AgGaSe₂, Ag(In,Al)Se₂, Ag(In,Ga)Se₂, or AgIn(S,Se)₂. When a compound semiconductor layer having a chalcopyrite structure, a stannite structure, or a kesterite structure is used to form the light absorbing layer for the photoelectric conversion device, the contact between the light absorbing layer and the bottom electrode 2 may cause the Voc to be lower than that obtained when other types of light absorbing layer are used. In an embodiment, therefore, the intermediate layer 3 is provided between the bottom electrode 2 and the p-type light absorbing layer 4 to improve the contact and to increase the conversion efficiency of the photoelectric conversion device. For example, it is suggested that when Se is used as the group IIIb element in the p-type light absorbing layer 4 and Mo is used to form the bottom electrode 2, the oxide or sulfide in the intermediate layer 3 can suppress the formation of MoSe₂ so that a work function close to that of Mo itself can be obtained, which can make it easy to achieve a high open-circuit voltage. It is also suggested that in the case of the transparent electrode, the intermediate layer 3 can increase the work function of the transparent electrode-side interface so that a high open-circuit voltage can be achieved.

In an embodiment, the p-type light absorbing layer 4 may be formed by sputtering, molecular beam epitaxy, chemical vapor deposition, slurry method, plating, spraying, or other techniques.

In an Ar (argon)-containing atmosphere, the sputtering is preferably performed at a temperature of the substrate (a member composed of the substrate 1 and the bottom electrode 2 formed thereon) of 10°C to 400°C, more preferably 250°C to 350°C. If the temperature of the substrate 1 is too low, the p-type light absorbing layer 4 will be formed with poor crystallinity. On the other hand, if the temperature is too high, the reaction can proceed excessively on the surface where the p-type light absorbing layer 4 is being formed, so that due to the mixing of the components, the product can fail to have the desired structure or due to unstable constituent elements at high temperature, defects can easily form. After the deposition of the light absorbing layer, annealing may also be performed to control the growth of crystal grains. To suppress the release of Se from the surface, it is preferable to mask the Se with an element with a high affinity for Se.

### (N-type semiconductor layer)

In an embodiment, the n-type layer 5 is an n-type semiconductor layer. The n-type layer 5 is formed on the principal surface of the p-type light absorbing layer 4 opposite to the intermediate layer 3. The n-type layer 5 forms a homojunction or a heterojunction with the light absorbing layer 4. The n-type layer 5 is preferably an n-type semiconductor whose Fermi level is so controlled that the photoelectric conversion device can have a high open-circuit voltage. The homojunction-forming n-type layer 5 is a layer formed by doping a certain region of the p-type light absorbing layer 4 as an original part with a dopant to convert the p-type to the n-type. The heterojunction-forming n-type layer 5 may include, for example, Zn_{1-y}M_{y}O₁₋ₓSₓ, Zn_{1-y-z}Mg_{z}M_{y}O, ZnO₁₋ₓSₓ, Zn_{1-z}Mg_{z}O (M is at least one element selected from the group consisting of B, Al, In, and Ga), CdS, n-type GaP with a controlled carrier concentration, or the like. The n-type layer 5 preferably has a thickness of 10 nm to 800 nm.

The method of doping part of the light absorbing layer 4 with a dopant to convert the p-type to the n-type may be an immersion method, a spraying method, a spin coating method, a vapor method, or the like. The immersion method may include, for example, immersing the principal surface of the p-type light absorbing layer 4, opposite to its substrate 1 side, in a solution (e.g., an aqueous sulfate solution) at 10°C to 90°C containing an n-type dopant such as Cd (cadmium) or Zn (zinc) and any one of Mg, Ca, and the like; and stirring the solution for about 25 minutes. The treated member is taken out of the solution, which is preferably followed by washing its surface with water and then drying it. The heterojunction-forming n-type layer 5 may be deposited by, for example, sputtering or CBD (chemical bath deposition).

### (Oxide layer)

In an embodiment, the oxide layer 6 is a thin film provided on the n-type layer 5. The oxide layer 6 may be a thin film including at least one compound selected from Zn₁₋ₓMgₓO, ZnO_{1-y}S_{y}, and Zn₁₋ₓMgₓO_{1-y}S_{y} (0 ≤ x, y < 1). The oxide layer 6 may be such that it does not cover the entire surface of the n-type layer 5 on the transparent electrode 7 side. For example, the oxide layer 6 may cover 50% of the surface of the n-type layer 5 on the transparent electrode 7 side. In view of environmental issues, the oxide layer 6 is preferably made of a Cd-free compound. Other candidates for the oxide layer 6 include wurtzite-type AlN, GaN, BeO, and the like. When the oxide layer 6 has a volume resistivity of 1 Ωcm or more, it is advantageous in that a leakage current can be suppressed, which would otherwise be derived from a low-resistance component potentially existing in the p-type light absorbing layer 4. In an embodiment, the oxide layer 6 may be omitted.

The oxide layer 6 can improve the conversion efficiency of the photoelectric conversion device having the homojunction-type light absorbing layer. In order to improve the conversion efficiency, the oxide layer 6 preferably has an average thickness of 1 nm to 30 nm. The average thickness of the oxide layer 6 can be determined from a cross-sectional image of the photoelectric conversion device. When the light absorbing layer 4 is of a heterojunction type, a buffer layer should be formed with a thickness of several tens nm, typically, 50 nm, but the oxide layer 6 on the n-type layer 5 should include a film thinner than such a buffer layer. When the photoelectric conversion device has the heterojunction-type light absorbing layer, it is not preferable to make the oxide layer 6 as thick as the n-type layer 5 in an embodiment because the conversion efficiency can decrease in such a case. When the photoelectric conversion device has the homojunction-type light absorbing layer, it is preferable to further provide a thin oxide layer between the oxide layer 6 and the n-type layer 5. In this case, such a thin oxide layer preferably has a thickness of, for example, 1 nm to 10 nm, and the oxide layer 6 preferably has a thickness of, for example, 5 nm to 40 nm. Such a structure is advantageous in that it can reduce the damage to the light absorbing layer during the deposition.

The oxide layer 6 is preferably a film for preventing the permeation of oxygen or damages during the formation of the transparent electrode 7 and preventing the degradation of the n-type layer 5. Even when the oxide layer 6 does not cover the entire surface of the n-type layer 5, the oxide layer 6 can function as an anti-oxidation film at a certain site. The prevention of the oxidation of the n-type layer 5 can advantageously improve the conversion efficiency. In order to prevent the permeation of oxygen, the oxide layer 6 is preferably a hard film. Such a hard film is preferably formed by at least one method selected from chemical liquid deposition, chemical vapor deposition, physical vapor deposition, and spin coating. The oxide layer 6 may be a film of an oxide as long as it is a hard film. The term "hard film" means a dense film with a high density. If the n-type layer 5 is damaged during the deposition of the oxide layer 6, a surface recombination center can form. For low-damage deposition, the method of forming the oxide layer 6 is preferably chemical liquid deposition or spin coating among the methods listed above. When a thin film with a thickness of 1 nm to 30 nm is formed, the film deposition time should be reduced depending on the thickness. For example, if the deposition conditions for forming 60-nm-thick CdS by chemical liquid deposition require a reaction time of 420 seconds, the oxide layer 6 can be formed with a thickness of 5 nm under the same conditions except for a reaction time of 35 seconds. A method for controlling the thickness may include changing the concentration of the solution being prepared. The volume resistivity of the oxide layer 6 can be determined by, for example, a four-terminal method or the like, which is performed on the oxide layer deposited on a substrate of an insulator such as soda-lime glass.

### (Transparent electrode)

In an embodiment, the transparent electrode 7 is a film electrically conductive and transparent for light such as sunlight. The transparent electrode 7 is deposited by, for example, sputtering in an Ar atmosphere. For example, the transparent electrode 7 may include ZnO:Al produced with a ZnO target containing 2 wt% of alumina (Al₂O₃) or include ZnO:B containing B as a dopant derived from diborane or triethylboron. A semi-insulating layer, such as a (Zn,Mg)O layer, may be provided between the transparent electrode 7 and the oxide layer. Like the transparent electrode 7, the semi-insulating layer may also be deposited by sputtering.

### (Top electrode)

In an embodiment, the top electrode 8 as an electrode of the photoelectric conversion device 100 is a metal film formed on the transparent electrode 7. The top electrode 8 may be a film of a conductive metal such as Ni or Al. The top electrode 8 typically has a thickness of 200 nm to 2,000 nm. The top electrode 8 may be omitted when the transparent electrode 7 has a low resistance so that the series resistance component is negligible.

### (Antireflective film)

In an embodiment, the antireflective film 9 is a film provided to facilitate the introduction of light into the p-type light absorbing layer 4. The antireflective film 9 is formed on the transparent electrode 7. The antireflective film 9 is preferably made of, for example, MgF₂ or SiO₂. In an embodiment, the antireflective film 9 may be omitted. The composition of the photoelectric conversion device 100 and the thickness of the components thereof can be analyzed by subjecting the photoelectric conversion device to secondary ion mass spectrometry (SIMS). The interface and crystals of each layer of the photoelectric conversion device 100 can be observed by the method described above for the intermediate layer 3.

Hereinafter, embodiments will be more specifically described with reference to examples.

### (Example 1)

A p-electrode of Mo was formed on a 16-mm-long, 12.5-mm-wide, 1.8-mm-thick, soda-lime glass substrate by sputtering in an Ar stream using a target made of elemental Mo. The p-electrode had a thickness of 500 nm. A 1-nm-thick intermediate layer of MgO was then formed by sputtering. A light absorbing layer was formed on the intermediate layer on the p-electrode on the soda-lime glass by molecular beam epitaxy. The light absorbing layer had a thickness of 2 µm. Subsequently, Zn was diffused into the CIGS light absorbing layer by an immersion method so that its surface part, where an oxide layer and a transparent electrode were to be formed, was converted to an n-type region. The resulting n-type region had a depth of 300 nm from the surface of the light absorbing layer to its bottom part. An oxide layer of Zn(O,S) was further formed with an average thickness of 1 nm on the n-type region by chemical liquid deposition. A (Zn,Mg)O layer was then formed by spin coating, and sputtering in an Ar stream was further performed on the oxide layer, so that the (Zn,Mg)O layer was formed as a semi-insulating layer and (Zn,Mg)O:Al was formed as a transparent electrode on the semi-insulating layer. Subsequently, an n-electrode of Ni and Al and an antireflective film of MgF₂ were formed, so that a photoelectric conversion device of an embodiment was obtained.

### (Examples 2 to 30 and Comparative Examples 1 to 12)

Photoelectric conversion devices of Examples 2 to 30 and Comparative Examples 1 to 12 were obtained as in Example 1, except that the bottom electrode, the intermediate layer, and the light absorbing layer were composed as shown in Tables 1 and 2.

At for the data in Tables 1 and 2, for example, the data on Example 24 show that the substrate, ITO, SnO₂, TiO₂, Mo, and the light absorbing layer are stacked in this order to form the photoelectric conversion device. The bottom electrode and the intermediate layer were all formed by sputtering, whereas the light absorbing layer was formed by MBE.

**[Table 1A]**

| | Configuration of Layer (from Left column, from Substrate Side to Light Absorbing Layer Side) | | | | |
|---|---|---|---|---|---|
| Example 1 | Mo(500nm) | MgO(0.5nm) | - | - | - |
| Example 2 | Mo(500nm) | MgO(1nm) | - | - | - |
| Example 3 | Mo(500nm) | MgO(2nm) | - | - | - |
| Example 4 | Mo(500nm) | MgO(5nm) | - | - | - |
| Example 5 | Mo(500nm) | MgO(8nm) | - | - | - |
| Example 6 | Mo(500nm) | MgO(10nm) | - | - | - |
| Example 7 | Mo(100nm) | MgO(1nm) | - | - | - |
| Example 8 | Mo(1000nm) | MgO(1nm) | - | - | - |
| Example 9 | Mo(500nm) | CaO(3nm) | - | - | - |
| Example 10 | Mo(500nm) | Al₂O₃(3nm) | - | - | - |
| Example 11 | Mo(500nm) | TiO₂(5nm) | - | - | - |
| Example 12 | Mo(500nm) | Ta₂O₅(2nm) | - | - | - |
| Example 13 | Mo(500nm) | SrTiO₃(3nm) | - | - | - |
| Example 14 | Mo(500nm) | MgO(1nm) | - | - | - |
| Example 15 | Mo(500nm) | MgO(1nm) | - | - | - |
| Example 16 | Mo(500nm) | MgO(1nm) | - | - | - |
| Example 17 | Mo(500nm) | MgO(1nm) | - | - | - |
| Example 18 | W(500nm) | MgO(1nm) | - | - | - |
| Example 19 | ITO(100nm) | Mo(5nm) | - | - | - |
| Example 20 | ITO(100nm) | Mo(10nm) | - | - | - |
| Example 21 | ITO(100nm) | Mo(10nm) | MgO(2nm) | - | - |
| Example 22 | ITO(100nm) | SnO2(150nm) | Mo (5nm) | - | - |
| Example 23 | ITO(100nm) | SnO2(150nm) | Mo(10nm) | MgO( 2nm) | - |
| Example 24 | ITO(100nm) | SnO2(150nm) | TiO₂ (10nm) | Mo(5 nm) | - |
| Example 25 | ITO(100nm) | SnO2(150nm) | TiO₂ (10nm) | Mo(5 nm) | MgO (2nm) |
| Example 26 | ITO(100nm) | SnO2(150nm) | TiO₂ (10nm) | Mo(5 nm) | MgO (5nm) |

**[Table 1B]**

| | Light Absorbing Layer |
|---|---|
| Example 1 | CuIn_{0.7}Ga_{0.3}Se₂ |
| Example 2 | CuIn_{0.7}Ga_{0.3}Se₂ |
| Example 3 | CuIn_{0.7}Ga_{0.3}Se₂ |
| Example 4 | CuIn_{0.7}Ga_{0.3}Se₂ |
| Example 5 | CuIn_{0.7}Ga_{0.3}Se₂ |
| Example 6 | CuIn_{0.7}Ga_{0.3}Se₂ |
| Example 7 | CuIn_{0.7}Ga_{0.3}Se₂ |
| Example 8 | CuIn_{0.7}Ga_{0.3}Se₂ |
| Example 9 | CuIn_{0.7}Ga_{0.3}Se₂ |
| Example 10 | CuIn_{0.7}Ga_{0.3}Se₂ |
| Example 11 | CuIn_{0.7}Ga_{0.3}Se₂ |
| Example 12 | CuIn_{0.7}Ga_{0.3}Se₂ |
| Example 13 | CuIn_{0.7}Ga_{0.3}Se₂ |
| Example 14 | CuGaSe₂ |
| Example 15 | CuGaSe_{1.8}S_{0.2} |
| Example 16 | AgGaSe₂ |
| Example 17 | AgIn_{0.2}Ga_{0.2}Se_{1.8}S_{0.2} |
| Example 18 | CuIn_{0.7}Ga_{0.3}Se₂ |
| Example 19 | CuIn_{0.7}Ga_{0.3}Se₂ |
| Example 20 | CuIn_{0.7}Ga_{0.3}Se₂ |
| Example 21 | CuIn_{0.7}Ga_{0.3}Se₂ |
| Example 22 | CuIn_{0.7}Ga_{0.3}Se₂ |
| Example 23 | CuIn_{0.7}Ga_{0.3}Se₂ |
| Example 24 | CuIn_{0.7}Ga_{0.3}Se₂ |
| Example 25 | CuIn_{0.7}Ga_{0.3}Se₂ |
| Example 26 | CuIn_{0.7}Ga_{0.3}Se₂ |

**[Table 2A]**

| | Configuration of Layer(from Left column, from Substrate Side to Light Absorbing Layer Side) | | | | |
|---|---|---|---|---|---|
| Example 27 | ITO(100nm) | SnO₂(150nm) | TiO₂(0nm) | Mo (5nm) | MgO (8nm) |
| Example 28 | ITO(100nm) | SnO₂(150nm) | TiO₂(10nm) | Mo(10nm) | MgO (2nm) |
| Example 29 | Mo(500nm) | MgS(1nm | - | - | - |
| Comparative Example 1 | Mo(500nm) | - | - | - | - |
| Comparative Example 2 | Mo(100nm) | - | - | - | - |
| Comparative Example 3 | Mo(1000nm) | - | - | - | - |
| Comparative Example 4 | Mo(500nm) | MgO(15nm) | - | - | - |
| Comparative Example 5 | Mo(500nm) | - | - | - | - |
| Comparative Example 6 | Mo(500nm) | - | - | - | - |
| Comparative Example 7 | Mo(500nm) | - | - | - | - |
| Comparative Example 8 | Mo(500nm) | - | - | - | - |
| Comparative Example 9 | W(500nm) | - | - | - | - |
| Comparative Example 10 | ITO(100nm) | - | - | - | - |
| Comparative Example 11 | ITO(100nm) | SnO₂(150nm) | - | - | - |
| Comparative Example 12 | ITO(100nm) | SnO₂(150nm) | TiO₂(10nm) | - | - |

**[Table 2B]**

| | Light Absorbing Layer |
|---|---|
| Example 27 | CuIn_{0.7}Ga_{0.3}Se₂ |
| Example 28 | CuIn_{0.7}Ga_{0.3}Se₂ |
| Example 29 | CuIn_{0.7}Ga_{0.3}Se₂ |
| Comparative Example 1 | CuIn_{0.7}Ga_{0.3}Se₂ |
| Comparative Example 2 | CuIn_{0.7}Ga_{0.3}Se₂ |
| Comparative Example 3 | CuIn_{0.7}Ga_{0.3}Se₂ |
| Comparative Example 4 | CuIn_{0.7}Ga_{0.3}Se₂ |
| Comparative Example 5 | CuGaSe₂ |
| Comparative Example 6 | CuGaSe_{1.8}S_{0.2} |
| Comparative Example 7 | AgGaSe₂ |
| Comparative Example 8 | AgIn_{0.2}Ga_{0.7}Se_{1.7}S_{0.2} |
| Comparative Example 9 | CuIn_{0.7}Ga_{0.3}Se₂ |
| Comparative Example 10 | CuIn_{0.7}Ga_{0.3}Se₂ |
| Comparative Example 11 | CuIn_{0.7}Ga_{0.3}Se₂ |
| Comparative Example 12 | CuIn_{0.7}Ga_{0.3}Se₂ |

The conversion efficiencies of the photoelectric conversion devices of the examples and the comparative examples were determined.

Tables 3 and 4 show the conversion efficiency (η = Voc·Jsc·FF/P·100 [%]) of each photoelectric conversion device. Tables 3 and 4 show the conversion efficiency of each of the examples, the comparative examples, and the reference examples with reference to that of Comparative Example 1 without the oxide layer. The conversion efficiency was evaluated at room temperature (25°C) using a solar simulator with an AM1.5 light source and using a prober.

**[Table 3]**

| | Voc(V) | Jsc (mA/cm²) | FF(%) | Eff. (%) |
|---|---|---|---|---|
| Example 1 | 0.608 | 34.7 | 0.782 | 16.49 |
| Example 2 | 0.616 | 34.8 | 0.782 | 16.76 |
| Example 3 | 0.615 | 34.2 | 0.779 | 16.38 |
| Example 4 | 0.613 | 34.3 | 0.776 | 16.31 |
| Example 5 | 0.603 | 34.3 | 0.775 | 16.02 |
| Example 6 | 0.601 | 33.8 | 0.681 | 13.83 |
| Example 7 | 0.615 | 34.5 | 0.780 | 16.54 |
| Example 8 | 0.616 | 34.8 | 0.783 | 16.78 |
| Example 9 | 0.610 | 34.8 | 0.780 | 16.55 |
| Example 10 | 0.604 | 34.9 | 0.778 | 16.39 |
| Example 11 | 0.618 | 34.6 | 0.781 | 16.69 |
| Example 12 | 0.605 | 34.7 | 0.781 | 16.39 |
| Example 13 | 0.609 | 34.6 | 0.779 | 16.41 |
| Example 14 | 1.09 | 17.6 | 0.774 | 14.84 |
| Example 15 | 1.22 | 13.5 | 0.752 | 12.38 |
| Example 16 | 1.12 | 15.5 | 0.771 | 13.38 |
| Example 17 | 1.21 | 11.5 | 0.741 | 10.31 |
| Example 18 | 0.61 | 34.8 | 0.700 | 14.85 |
| Example 19 | 0.61 | 34.9 | 0.780 | 16.60 |
| Example 20 | 0.61 | 34.8 | 0.781 | 16.57 |
| Example 21 | 0.62 | 34.9 | 0.779 | 16.85 |
| Example 22 | 0.62 | 34.9 | 0.781 | 16.89 |
| Example 23 | 0.618 | 34.6 | 0.770 | 16.46 |
| Example 24 | 0.623 | 34.7 | 0.782 | 16.90 |
| Example 25 | 0.621 | 34.4 | 0.782 | 16.70 |
| Example 26 | 0.618 | 34.3 | 0.780 | 16.53 |

**[Table 4]**

| | Voc(V) | Jsc (mA/cm²) | FF(%) | Eff. (%) |
|---|---|---|---|---|
| Example 27 | 0.616 | 33.9 | 0.779 | 16.26 |
| Example 28 | 0.617 | 34.5 | 0.783 | 16.66 |
| Example 29 | 0.613 | 34.7 | 0.780 | 16.59 |
| Comparative Example 1 | 0.600 | 35.0 | 0.776 | 16.29 |
| Comparative Example 2 | 0.595 | 34.2 | 0.774 | 15.75 |
| Comparative Example 3 | 0.602 | 34.8 | 0.781 | 16.36 |
| Comparative Example 4 | 0.45 | 10.5 | 0.261 | 1.23 |
| Comparative Example 5 | 1.06 | 17.5 | 0.769 | 14.26 |
| Comparative Example 6 | 1.18 | 13.6 | 0.762 | 12.22 |
| Comparative Example 7 | 1.09 | 15.4 | 0.772 | 12.95 |
| Comparative Example 8 | 1.17 | 11.6 | 0.735 | 9.97 |
| Comparative Example 9 | 0.595 | 34.9 | 0.702 | 14.57 |
| Comparative Example 10 | 0.595 | 34.8 | 0.775 | 16.04 |
| Comparative Example 11 | 0.605 | 34.8 | 0.776 | 16.33 |
| Comparative Example 12 | 0.615 | 34.8 | 0.777 | 16.62 |

It has been demonstrated that the insertion of a thin intermediate layer can improve the conversion efficiency of photoelectric conversion devices. It has also been demonstrated that oxide layers with a thickness in the range of 1 nm to 5 nm can increase the conversion efficiency with similar tendencies for the thickness regardless of the type of the compound of the oxide layer.

If MgO is too thick, it can form a high-resistance component, which can reduce the Voc and the Jsc and thus the conversion efficiency. Mo with a thickness of 1,000 nm can be more effective in improving the open-circuit voltage. This indicates that the contribution of Mo to the resistance component increases with increasing thickness of Mo. It is also apparent that all the systems in which 1-nm-thick MgO is incorporated have an improved open-circuit voltage and an improved efficiency. This is because MgO improves the contact with a film of a metal such as Mo or W. It is suggested that MgO can inhibit the formation of MoSe₂ or WSe₂ from Mo or W, so that a work function close to that of the metal itself can be obtained, which can contribute to an increase in the open-circuit voltage as a result. When a transparent electrode is used, the introduction of thin Mo improves the open-circuit voltage, which suggests that it can improve the contact. It is apparent that MgO is still effective even when Mo is relatively thick (10 nm).

In the description, some elements are represented only by their symbols.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A photoelectric conversion device comprising:
a bottom electrode;
an intermediate layer on the bottom electrode;
a p-type light absorbing layer on the intermediate layer; and
an n-type layer on the p-type light absorbing layer, wherein
the bottom electrode is a first metal film or a semiconductor film, when
the bottom electrode is a metal film, the intermediate layer comprises an oxide film or a sulfide film, and when
the bottom electrode is a semiconductor film, the intermediate layer comprises a second metal film and an oxide film or a sulfide film on the second metal film.

2. The device according to claim 1, wherein when the bottom electrode is a metal film, the intermediate layer comprises an oxide film or a sulfide film with a thickness of 10 nm or less.

3. The device according to claim 1 or 2, wherein when the bottom electrode is a semiconductor film, the intermediate layer comprises a second metal film with a thickness of 10 nm or less and an oxide film or a sulfide film with a thickness of 10 nm or less on the second metal film.

4. The device according to any one of claims 1 to 3, wherein the oxide or sulfide film is a film of an oxide or sulfide containing at least one element selected from Mg, Ca, Al, Ti, Ta, and Sr.

5. The device according to any one of claims 1 to 4, wherein the first metal film is a film comprising Mo or W.

6. The device according to any one of claims 1 to 5, wherein the second metal film is a film comprising Mo or W.

7. The device according to any one of claims 1 to 6, wherein the semiconductor film comprises at least an indium tin oxide film.

8. The device according to any one of claims 1 to 7, wherein the semiconductor film comprises a stack of indium tin oxide and one or both of SnO₂ and TiO₂.

9. The device according to any one of claims 1 to 8, wherein the p-type light absorbing layer is a layer of a compound semiconductor having a chalcopyrite structure, a stannite structure, or a kesterite structure.

10. A solar cell comprising a photoelectric conversion device, the photoelectric conversion device according to any one of the preceding claims.
